## Europäisches Patentamt
## European Patent Office
## Office européen des brevets

(19)

(11) Publication number: **0 208 935**
**B1**

(12) # EUROPEAN PATENT SPECIFICATION

(45) Date of publication of the patent specification: **29.03.89**

(51) Int. Cl.⁴: **H 01 L 21/82**

(21) Application number: **86108257.6**

(22) Date of filling: **18.06.86**

(54) Narrow channel width fet.

(30) Priority: **19.06.85 JP 133831/85**

(43) Date of publication of application:
**21.01.87 Bulletin 87/4**

(45) Publication of the grant of the patent:
**29.03.89 Bulletin 89/13**

(84) Designated Contracting States:
**DE FR GB**

(56) References cited:
**DE-A-2 640 694**
**GB-A-2 123 605**

**IEEE TRANSACTIONS ON ELECTRON DEVICES,
vol. ED-20, no. 12, December 1973, pages 1129-1132,
New York, US; R.A. MOLINE et al.: "Self-aligned
maskless chan stops for IGFET integrated circuits"
PATENT ABSTRACTS OF JAPAN, vol. 6, no. 67 (E-
104) 945 , 28th April 1982; & JP-A-57 7153**

(73) Proprietor: **FUJITSU LIMITED, 1015, Kamikodanaka
Nakahara- ku, Kawasaki- shi Kanagawa 211 (JP)**

(72) Inventor: **Shirato, Takehide c/o Fujitsu Ltd.
Patent Dept., Kosugi Fujitsu Building 1812- 10,
Shimonumabe, Nakahara- ku Kawasaki- shi
Kanagawa, 211 (JP)**
Inventor: **Ema, Taiji c/o Fujitsu Ltd. Patent Dept.,
Kosugi Fujitsu Building 1812- 10, Shimonumabe,
Nakahara- ku Kawasaki- shi Kanagawa, 211 (JP)**

(74) Representative: **Sunderland, James Harry,
HASELTINE LAKE & CO Hazlitt House 28
Southampton Buildings Chancery Lane, London
WC2A 1AT (GB)**

## Description

The present invention relates to narrow channel width FET's.

Towards achievement of increased packing density and speed, and in relation to reduction of power consumption of semiconductor integrated circuits (ICs), the scaling or size of devices such as transistors in the circuits is a major concern for semiconductor IC manufacturers. For obtaining increased speed, channel lengths of IG-FETs (insulated-gate field effect transistors) or MIS-FETs (metal-insulator-semiconductor field effect transistors) in integrated circuits have been decreasedand can approach as little as 1.5 micrometers. Means affording further decreases in channel length are still being devised. Further, reductions in channel width are being sought in order to decrease power consumption in IG-FETs which are not required to offer high speed and large current capacity. When the channel width of an IG-FET is reduced to a size approaching 2 micrometers or less, the threshold voltage of the FET rises as the width decreases. This phenomenon of threshold voltage increase with narrowing of channel width is believed to have a structural cause (W.A. Nobel et al. "Narrow Channel Effect in Insulated Gate Field Effect Transistors" Proc. of IEEE 1976 International Electron Devices, pp. 582 - 586) and to be connected with impurities diffused from a region around the channel, particularly impurities which are doped into the field for establishing a desired field inversion threshold voltage.

Such impurities are selectively doped into the field around an active region (transistor region) in which an FET is formed. The impurities are diffused downwardly in the semiconductor substrate, to be distributed below a field oxide layer, during a heat treatment process used growing the field oxide layer. A region doped with such impurities, below a field oxide layer, is referred to as a channel stopper. However, concurrently with the downward diffusion of the impurities, a lateral diffusion of the impurities into the active region occurs. The extent of the lateral diffusion corresponds to the depth of the downward diffusion. Thus, as a result of the lateral diffusion, the active region is encroached upon and diminished. Since the impurities forming a channel stopper have a conductivity type the same as that of the portion of the substrate or well in which an associated IG-FET is formed, the threshold voltage of the associated FET increases if the impurity concentration in the channel of the FET is increased by the laterally diffused impurities.

A technology known as channel doping may be employed for adjusting the threshold voltage of an IG-FET to a desired level. By selecting the conductivity type and the dosage of channel doping impurities, the FET can be characterised as a depletion or enhancement type, with desired conductivity type and threshold voltage. Channel doping is sometimes performed relatively deeply into a substrate so as to create a well. Impurity concentration in the well is controlled to establish a desired threshold voltage for an IG-FET formed therein.

However, with the channel doping technique, a relatively low dosage of impurities is concurrently applied in general to all IG-FETs having the same conductivity type, formed on a semiconductor substrate. The concentration of impurities arising as a result of lateral diffusion as discussed above is higher than that dealt with in channel doping. Accordingly, if an IG-FET having a narrow channel width is formed together with an IG-FET having a relatively wider channel width on a semiconductor substrate, the threshold voltage increase suffered by the narrow channel width IG-FET due to lateral diffusion cannot be controlled by conventional channel doping technology. Thus, a narrow channel width IG-FET, having a channel width of 2 microns or less, has not been put into practical use much less incorporated in an IG chip including also conventional wider channel IG-FETs.

According to the present invention there is provided a method of fabricating a field-effect transistor (FET) in a transistor region in a semiconductor substrate, the transistor region including a channel region destined to have the channel of the FET formed therein, comprising:

- selectively injecting first impurities, of a first conductivity type, into the semiconductor substrate around the transistor region;

- subjecting the semiconductor substrate to a heat process for diffusing the first impurities, causing the first impurities to be distributed throughout or throughout a greater part of the channel region; and

- selectively injecting second impurities, of a second conductivity type, into the transistor region, so that the first impurities in at least the channel region are substantially compensated by the second impurities.

An embodiment of the present invention can provide for the prevention of threshold voltage increase in a narrow channel width IG-FET.

An embodiment of the present invention can provide for the fabrication of a narrow channel width IG-FET which can be put to practical use.

An embodiment of the present invention can provide for the incorporation of a narrow channel width IG-FET into an integrated circuit including also a wide channel width IG-FET.

An embodiment of the present invention can provide for the fabrication of an IG-FET in a predetermined transistor region in a semiconductor substrate, by a fabrication method comprising steps of selectively injecting first impurities having a first conductivity type into the semiconductor substrate around the transistor region, subjecting the substrate to a hea treatment process for diffusing the first impurities to distribute those impurities throughout the channel regio, of the IG-FET, and selectively injecting second impurities having a second conductivity type into the transistor region so that the first impurities in at least the channel region are substantially compensated by the second impurities. The threshold voltage of the IG-FET is adjusted at a desired level by injecting third impurities into the channel region.

An embodiment of the present invention can provide an insulated gate field effect transistor (IG-FET) having a channel whose width is so narrow that the threshold voltage of the transistor would be increased by lateral diffusion of field impurities doped to form a so-called channel stopper, wherein the threshold voltage is kept down to a desired level even when the channel is entirely filled with laterally diffused field impurities.

Reference is made, by way of example, to the accompanying drawings, in which:

FIGURE 1A is a schematic plan view of an IG-FET formed in a transistor region, illustrating a gate electrode of the FET and a field oxide layer formed around the transistor region;

FIGURES 1B and 1C are schematic cross-sectional views, taken along the lines A-A and B-B in Figure 1A respectively, illustrating a channel stopper formed under the field oxide layer and encroaching on the transistor region;

FIGURE 2 is a schematic cross-sectional view, taken in the channel width direction of an IG-FET having a narrow width channel, illustrating the encroachment of impurities diffused from a channel stopper formed to surround the channel;

FIGURES 3A-3G are respective, schematic, cross-sectional views illustrating the fabrication of an IG-FET device in accordance with an embodiment of the present invention; and

FIGURE 4 is a schematic cross-sectional view taken in a direction perpendicular to the gate electrode 14b in Figure 3F.

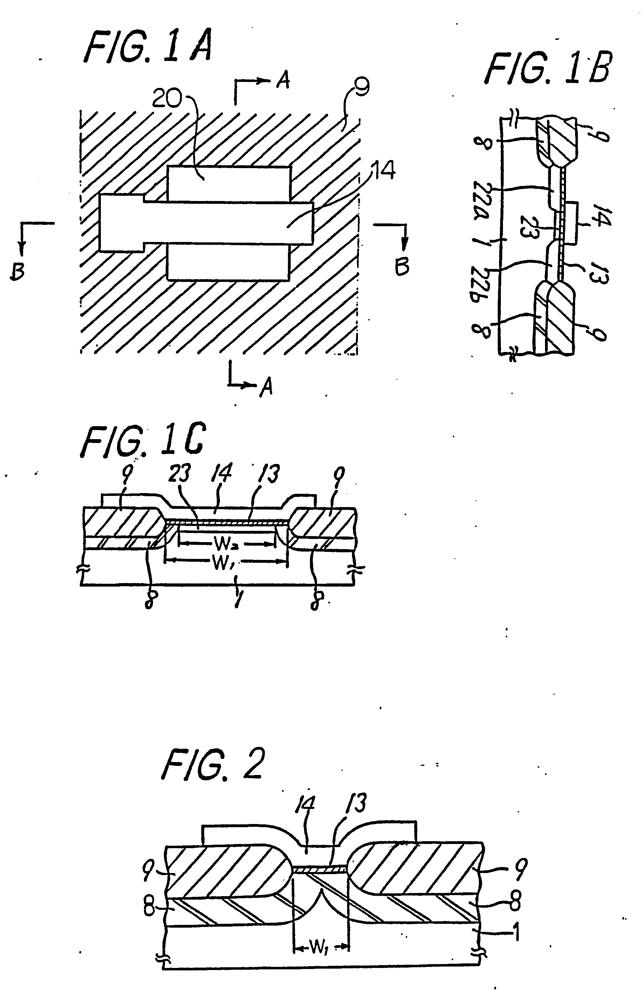

The schematic plan view of Figure 1A, of an IG-FET formed in a transistor region 20, illustrates a gate electrode 14 of the FET and a field oxide layer 9 formed around the transistor region 20. The schematic cross-sectional views of Figures 1B and 1C, corresponding to lines A-A and B-B in Figure 1A respectively, illustrate a channel stopper 8 formed under the field oxide layer 9, a semiconductor substrate 1, source or drain regions 22a and 22b formed in the substrate 1, and gate electrode 14 formed above a channel region 23 on a gate insulating layer 13 formed on the substrate 1.

As shown in Figures 1B and 1C, the transistor region 20 is partially encroached upon by impurities diffused from the channel stopper 8. That is, a designed channel width WI, 10 micrometers, for example, is reduced to a narrower width W2, as shown in Figure 1C. In a channel length direction, as shown in Figure 1B, lateral impurity diffusion exhibits an encroachment on the source or drain regions 22a and 22b but does not extend to the channel region 23.

Figure 2 is a schematic cross-sectional view of a narrow width channel IG-FET in a channel width direction thereof. The extent of the encroachment upon the channel width by channel stopper impurities corresponds to the thickness of the channel stopper, which is generally 0.8 to 1 micrometer. Accordingly, if a designed channel width WI in Figure 2 is 1.5 micrometers or less, impurities diffused from the channel stopper 8 are distributed throughout the channel region, as shown in Figure 2. Thus, the impurity concentration in the channel region becomes much higher than that in the substrate 1, and the threshold voltage of the narrow channel width IG-FET increases, up to 3 volts for example, as compared with a threshold voltage of 0.7 volts for an SG-FET whose channel region is not fully encroached upon by channel stopper impurities (for example an IG-FET as shown in Figures 1A and 1B).

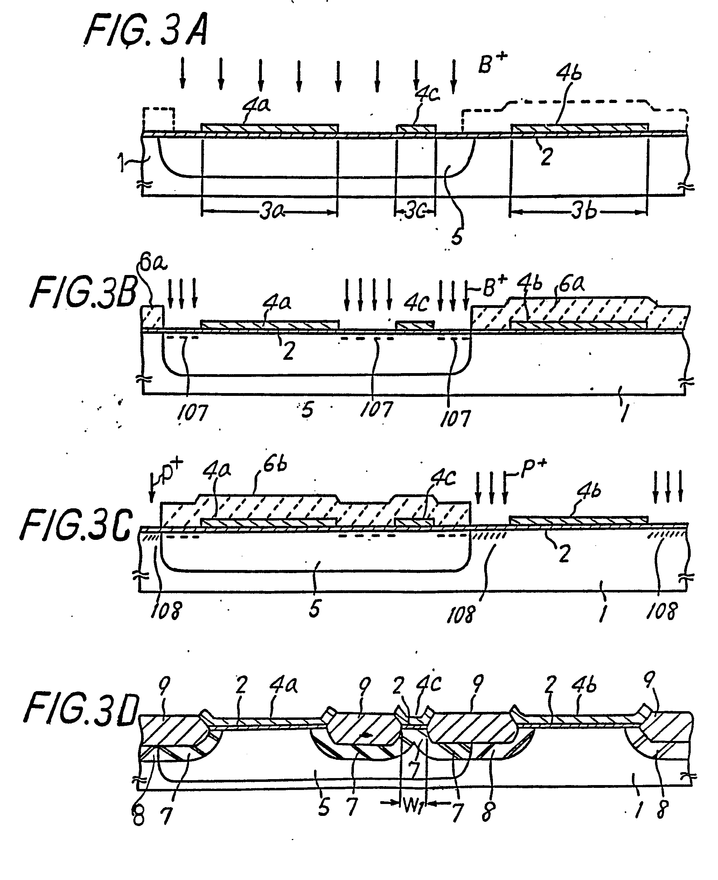

Figures 3A-3G are cross-sectional views for explaining the fabrication of a semiconductor device in accordance with an embodiment of the present invention, illustrating steps in a process for fabricating a narrow channel width IG-FET together with wider channel width IG-FETs on a semiconductor substrate. In this case, an n-type NOS (metal oxide semiconductor) FET having a channel width as narrow as 1.5 microns is involved. The narrow channel width NOS FET is formed in a p-type well during a series of processes for providing CMOS (complementary NOS) FETs having conventional channel widths as large as 10 micrometers.

Referring to Figure 3A, a thin silicon dioxide ($SiO_2$) layer 2 with a thickness in the range 50 to 100 mm (500 to 1000 A°) is formed on the surface of a low concentration n-type silicon substrate 1 having specific resistance of 1 ohm, for example. Then, using conventional CVD (chemical vapor deposition) and photolithographic technologies, patterns of silicon nitride ($Si_3N_4$) layers 4a, 4b and 4c are formed on the $SiO_2$ layer 2 so as to cover respective predetermined regions 3a, 3b and 3c on the surface of the substrate 1, those regions being assigned for forming therein an n-type NOS FET and a p-type MOS FET, having conventional channel widths, and an n-type MOS FET, having the narrow channel width, respectively.

A resist layer is applied to the surface of the substrate 1 and patterned to mask the region 3b and the periphery thereof, as shown by a broken line in Figure 3A. Then, boron ions ($B^+$) with an energy of 160 KeV, for example, are implanted to a dose, typically, of $1 \times 10^{13}$ ions/cm$^2$, so as to create a p-type well 5 in a portion of he substrate 1 unmasked by the resist layer. The implantation energy of the boron ions ($B^+$) is such that the ions can penetrate the $Si_3N_4$ layers 4a and 4c (and $SiO_2$ layer 2) but are substantially absorbed by the resist layer. The resist layer is then removed and the substrate 1 subjected to an annealing process, and thus, a p-type well 5 having a depth of approximately 3 micrometers is formed in a portion of the substrate. The ion implantation dosage is selected with a view to establishing a threshold voltage of 0.6 - 1.0 volts for the to-be-fabricated n-type MOS FETs in the well 5.

Subsequently a first resist layer 6a is applied to the surface of the substrate 1 and patterned to leave unmasked the substrate surface corresponding to the well 5, as shown in Figure 3B. Then, boron ions (B+) with an energy of 25 KeV, for example, are implanted in the unmasked region to a dose, typically, of $5 \times 10^{13}$ ions/cm². During this ion implantation, boron ions (B+) falling on the resist layer 6a are substantially absorbed therein. Further, the implantation energy of the boron ions (B+) is too low for the ions to penetrate the $Si_3N_4$ layer patterns 4a and 4c but is high enough for the ions to pass through the $SiO_2$ layer 2. Accordingly a selective implantation of boron atoms is provided in substrate portions 107 at the perphery of the $Si_3N_4$ layer patterns ha and 4c.

Following the above, the first resist layer 6a is removed and a second resist layer 6b is applied to the surface of the substrate 1 and patterned so as to selectively mask the well region 5, as shown in Figure 3C. Then, phosphorus ions (P+) with an energy of 60 KeV, for example, are implanted into unmasked regions to a dose, typically, of $3 \times 10^{12}$ ions/cm². During this ion implantation, phosphorus ions (P+) falling on the resist layer 6b are substantially absorbed therein. Further, the implantation energy of the phosphorus ions (P+) is too low for the ions to penetrate the $Si_3N_4$ layer pattern 4b, but high enough for the ions to pass through the $SiO_2$ layer 2. Hence, a selective implantation of phosphorus ions (P+) occurs in substrate portions 108 at the periphery of the pattern 4b.

After the resist layer 6b has been removed, the substrate 1 is subjected to a process for producing a field oxide layer according to a conventional LOCOS (local oxidation of silicon) technology. That is, the substrate 1 is heated in a wet oxygen atmosphere for about 10 hours at approximately 900° C, for example, with the $Si_3N_4$ layers 4a, 4b and 4c acting as masks. Thus, portions of the surface of the substrate around the $Si_3N_4$ layers 4a, 4b and 4c are selectively oxidized to form a thick $SiO_2$ layer 9, which is conventionally referred to as field oxide, as shown in Figure 3D. During the heating process, boron and phosphorus atoms implanted in the regions 107 and 108 (Figures 3B and 3C), respectively are activated to be distributed to a depth of approximately 0.8 micrometers below the field oxide 9, thus forming respective diffusion layers 7 and 8. The diffusion layers 7 and 8, each being conventionally referred to as a channel stopper, can improve the field threshold voltage characteristics of an IC comprising IG-FETs.

Each of the regions 3a, 3b and 3c is encroached on by diffusion layers 7 or 8, i.e. by impurities laterally diffused from the channel stoppers, as explained above with reference to Figures 1A to 1C. In particular, the region 3c, corresponding to an n-type MOS FET having a narrow channel width of 1.5 micrometers, is entirely encroached on by the p-type diffusion layer 7 having a thickness of 0.8 micrometers. Thus, the impurity concentration in the region 3c is almost the same as that in the diffusion layer (channel stopper) 7. As a result, the threshold voltage of the narrow channel width MOS FET to be formed in the region 3c is much higher than that of the conventional channel width MOS FET to be formed in the region 3a, as mentioned above.

Accordingly, in an embodiment of the present invention, another selective doping of opposite conductivity type impurities is employed to compensate the impurities diffused in the region 3c from the channel stopper 7. That is, in this case, n-type impurities are selectively implanted to the region 3c in which a narrow channel width MOS FET is to be formed, for compensating for the increase in p-type impurity concentration in the region.

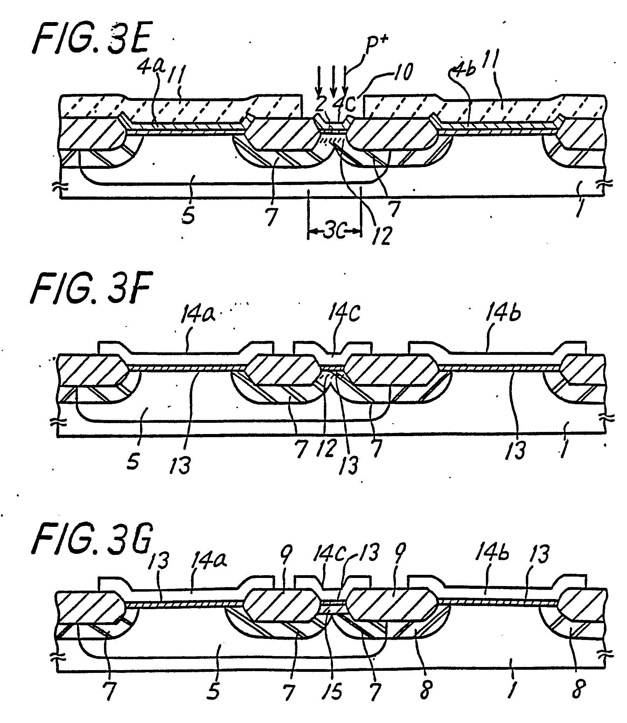

Referring to Figure 3E, a resist layer 11 having an opening 10 which exposes the region 3c is applied to the surface of the substrate 1, and phosphorus ions (P+) with an energy of 180 KeV are selectively implanted into the region 3c through the opening 10 to a dose in the range between $1 \times 10^{11}$ and $1 \times 10^{12}$ ions/cm². The phosphorus n-type impurities as implanted are concentrated in a region 12 adjacent to the surface of the substrate 1. In the above compensating implantation, the field oxide around the region 3c can serve as a mask, in addition to the resist layer 11. Therefore, the opening 10 can be designed to be larger than the dimensions of the region 3c, and hence, the alignment of the opening 10 with respect to the region 3c is facilitated.

After the above steps, MOS FETs, each having a narrow or wide channel, are fabricated in the respective regions 3a, 3b and 3c, according to conventional process steps. That is, $Si_3N_4$ layer patterns 4a, 4b and 4c and thin $SiO_2$ layer 2 are removed, and gate oxide layers 13 are formed on the surfaces of the substrate regions previously defined by the $Si_3N_4$ layer patterns 4a, 4b and 4c and now exposed through openings in the field oxide layer 9. The gate oxide layers can be produced by using a conventional thermal oxidation method. Subsequently, gate electrodes 14a, 14b and 14c, of polysilicon for example, are respectively formed on those regions over the respective gate oxide layers 13 as shown in Figure 3F, by using conventional CVD and photolithographic technologies.

Following the above, respective heavy dosages of n-type and p-type impurities are implanted in the substrate 1 and well 5, for providing sources and drains of the narrow and wider channel width MOS FETs. First, a photoresist layer is applied to the surface of the substrate 1 and patterned to mask the region 3b (indicated in Figure 3A) and the periphery thereof. Then, high doses of n-type impurities, arsenic ions (As+), for example, are implanted in both of the regions 3a and 3c (respectively indicated in Figures 3A and 3E), wherein each of the gate electrodes 14a and 14c serve as masks, in addition to the photoresist layer, during the selective implantation of the n-type impurities into the regions 3a and 3c. Thus, respective source and drain regions for narrow and wider channel width n-type MOS FETs are provided with high dosage of n-type impurities. For the implantation of arsenic ions (As+), an ion energy of 70 KeV and a dosage of $4 \times 10^{15}$ ions/cm$^2$ are employed.

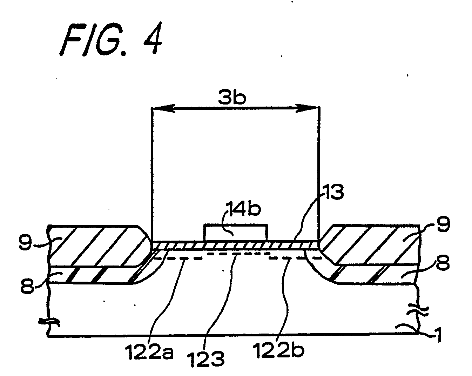

The photoresist mask is removed and another photoresist layer is applied to the surface of the substrate 1 and patterned to expose the region 3b. With this new photoresist mask, boron ions (B+), with an energy of 25 KeV, are implanted in the region 3b to a dose of $1 \times 10^{15}$ ions/cm$^2$ for creating source and drain regions of the wider channel width p-type MOS FET. Then, ion energy is increased to 180 KeV to perform channel doping of the substrate 1 through the gate electrode 14b, in relation to this wider channel width p-type MOS FET. The dosage employed in the channel doping is between $1 \times 10^{11}$ and $1 \times 10^{12}$ ions/cm$^2$. Figure 4 is a cross-sectional view taken in a direction perpendicular to the gate electrode 14b in Figure 3F. Thus, respective implantations of a relatively low concentration of boron atoms in a channel region 123 and of a relatively high concentration of boron atoms in respective source and drain regions 122a and 122b for the p-type MOS FET to be fabricated in the region 3b are achieved as shown in Figure 4.

Following the above, the substrate 1 is annealed to activate the impurities implanted in the regions 3a, 3b and 3c. That is, the arsenic atoms implanted as n-type impurities in the regions 3a and 3c and the boron atoms implanted as p-type impurities in the region 3b are activated to reveal their specific functions as the drains and sources. At the same time, the compensating phosphorus atoms concentrated in the region 12 adjacent to the surface of the substrate 1 in the region 3c as indicated in Figure 3E are activated and distributed to provide a channel region 15 as shown in Figure 3G. In the channel region 15, the impurities diffused from the p-type channel stopper 7 are compensated, and a threshold voltage of 0.6 to 1 volt is established for the narrow channel width MOS FET which is now formed in the region 3c, corresponding to the impurity concentration of the well 5.

Referring again to Figure 4, the boron atoms implanted in the regions 122a, 122b and 123 are also activated during the above annealing process and distributed to provide the source and drain and the channel for the p-type wider channel MOS FET formed in the region 3b. The arrangement of the regions is exemplified by the source and drain regions 22a and 22b and the channel region 23 shown in Figure 1B. Thus, according to an embodiment of the present invention, a narrow channel width MOS FET is fabricated to have a threshold voltage of 0.7 volts, for example, the same as that of wider channel width n-type and p-type MOS FETs formed together with the narrow channel width MOS FET on a semiconductor substrate, while a field inversion threshold voltage is maintained at a level 25 volts or larger.

As indicated with reference to the above-described embodiment, impurities diffused from a channel stopper and distributed throughout the channel region of a IG-FET having a channel width as narrow as 1.5 micrometers are compensated by opposite conductivity type dopants implanted in the channel region, and the threshold voltage of the IG-FET can be established at a level substantially equal to the threshold level of a conventional IG-FET having a relatively wider channel width, such as 10 micrometers. In other words, an embodiment of the present invention allows a semiconductor integrated circuit to be designed which includes an IG-FET with a channel width as narrow as 1.5 micrometer or less, without regard to the lateral impurity diffusion from the channel stopper.

An embodiment of the present invention can be applied to the fabrication of a narrow channel width IG-FET in a substrate, instead of in a well region as in the above-described embodiment. In such a case, channel doping for adjusting the threshold voltage of the narrow channel width FET may be carried out after the gate electrode thereof is formed on the channel region, in the same general manner as explained with reference to Figure 4 in which impurities for channel doping are implanted into the channel region 123 through the gate electrode 14b. Further, compensating impurities such as boron ions may be implanted through the gate electrode, whether the narrow channel width IG-FET is formed in a substrate or a well.

Moreover, an embodiment of the present invention can be applied to the fabrication of IG-FETs, in which the respective conductivity types of the substrate, well and impurities for compensation and channel doping are opposite to those of the above-described embodiment.

The compensation can generally be applied to IG-FETs other than narrow channel width IG-FETs.

Still further, an embodiment of the present invention can be effectively applied to the avoidance of a punch-through effect in a short channel length IG-FET. That is, with the channel width of a short channel length IG-FET decreased to 2 micrometers or less, a shallow compensating impurity implantation is provided for the channel region so as to leave a region containing a high concentration of laterally diffused impurities below the compensated region. In such a narrow width and short channel IG-FET, channel conduction is maintained in the shallow compensated region and punchthrough in deeper regions is prevented due to the high concentration of impurities below the compensated region.

In the above-described embodiment of the present invention, the channel region of a narrow channel width IG-FET is entirely occupied by the impurities diffused from the channel stopper formed around the FET. However, an embodiment of the present invention can also be effectively applied to a narrow channel width IG-FET in which the channel region is not entirely occupied by such laterally diffused high concentration impurities but includes a small space of a low impurity concentration, between the encroaching laterally diffused channel stopper impurities.

In the case of a narrow channel width IG-FET whose channel region is almost or entirely filled with or occupied by impurities diffused from a channel stopper formed to surround the IG-FET, an embodiment of the present invention enables the IG-FET to be fabricated with a threshold voltage at a level substantially the same as that of a conventional wider channel width IG-FET. Impurities having a conductivity type opposite to that of impurities diffused from the channel stopper are selectively injected at least into the channel region of the narrow channel width IG-FET, for compensating the diffused channel stopper impurities. Further impurities for channel doping may be employed to adjust threshold voltages of narrow and wider channel width IG-FETs as usual.

## Claims

1. A method of fabricating a field-effect transistor (FET) in a transistor region in a semiconductor substrate, the transistor region including a channel region destined to have the channel of the FET formed therein, comprising:
- selectively injecting first impurities, of a first conductivity type, into the semiconductor substrate around the transistor region,
- subjecting the semiconductor substrate to a heat process for diffusing the first impurities, causing the first impurities to be distributed throughout or throughout a greater part of the channel region; and
- selectively injecting second impurities, of a second conductivity type, into the transistor region, so that the first impurities in at least the channel region are substantially compensated by the second impurities.

2. A method as claimed in claim 1, further comprising injecting third impurities into at least the channel region, for adjusting the threshold voltage of the FET to a desired level.

3. A method as claimed in claim 2, wherein the concentration of the second impurities injected into the channel region is substantially equal to the concentration of the first impurities in the channel region, and the third impurities are of the second conductivity type, such that an FET of second conductivity depletion type can be provided.

4. A method as claimed in claim 2, wherein the third impurities are of the first conductivity type and the concentration of second impurities injected into the channel region is equal to or greater than the concentration of the first impurities in the channel region and less than the sum of the respective concentrations of the first and third impurities in the channel region, such than an FET of second conductivity enhancement type can be provided.

5. A method as claimed in claim 4, wherein the third impurities are injected so as to be distributed deeper into the substrate than the first impurities, thereby to provide a well of the first conductivity type in the semiconductor substrate, for forming therein the FET.

6. A method as claimed in any preceding claim, wherein either the first and/or the second impurities are ion injected.

7. A method as claimed in claim 2, 3, 4 or 5, or claim 6 when read as appended to claim 2, 3, 4 or 5, wherein the third impurities are ion injected.

8. A method as claimed in claim 7, further comprising:
- forming an insulating layer on the transistor region; and
- subsequently forming a gate electrode on the channel region, above the insulating layer,
- the third impurities being ion injected into the channel region through the gate electrode and the insulating layer.

9. A method as claimed in any preceding claim, wherein the width of the channel region is less than 2 micrometers.

10. A method as claimed in claim 9, wherein the FET is formed on the substrate together with another FET having a channel region wider than 2 micrometer.

## Patentansprüche

1. Verfahren zur Herstellung eines Feldeffekttransistors (FET) in einem Transistorbereich in einem Halbleitersubstrat, welcher Transistorbereich einen Kanalbereich enthält, der dazu bestimmt ist, daß der Kanal des FET darin geformt wird, mit:
- selektiver Injektion erster Verunreinigungen, von einem ersten Leitfähigkeitstyp, in das Halbleitersubstrat um den Transistorbereich;
- einer Wärmebehandlung des Halbleitersubstrats zur Diffusion von ersten Verunreinigungen, wodurch die ersten Verunreinigungen veranlaßt werden, vollständig durch oder durch einen größeren Teil des Kanalbereichs verteilt zu werden; und
- selektiver Injektion von zweiten Verunreinigungen, von einem zweiten Leitfähigkeitstyp, in den Transistorbereich, so daß die ersten Verunreinigungen wenigstens in dem Kanalbereich im wesentlichen durch die zweiten Verunreinigungen kompensiert werden.

2. Verfahren nach Anspruch 1, ferner mit Injektion von dritten Verunreinigungen wenigstens in den Kanalbereich, zum Einstellen der Schwellenwertspannung des FET auf einen gewünschten Pegel.

3. Verfahren nach Anspruch 2, bei dem die Konzentration der zweiten Verunreinigungen, die in den Kanalbereich injiziert werden, im wesentlichen gleich der Konzentration der ersten Verunreinigungen in dem Kanalbereich ist, und die dritten Verunreinigungen von dem zweiten Leitfähigkeits sind, so daß ein FET vom zweiten Leitfähigkeits-Verarmungstyp vorgesehen werden kann.

4. Verfahren nach Anspruch 2, bei dem die dritten Verunreinigungen von dem ersten Leitfähigkeitstyp sind und die Konzentration von zweiten Verunreinigungen, die in den Kanalbereich injiziert werden, gleich oder größer als die Konzentration der ersten Verunreinigungen in dem Kanalbereich und kleiner als die Summe der jeweiligen Konzentrationen der ersten und dritten Verunreinigungen in dem Kanalbereich ist, so daß ein FET vom zweiten Leitfähigkeits-Anreicherungstyp vorgesehen werden kann.

5. Verfahren nach Anspruch 4, bei dem die dritten Verunreinigungen so injiziert werden, daß sie tiefer als die ersten Verunreinigungen in das Substrat verteilt werden, um dadurch einen Potentialtopf vom ersten Leitfähigkeitstyp in dem Halbleitersubstrat vorzusehen, um darin den FET zu bilden.

6. Verfahren nach einem der vorhergehenden Ansprüche, bei dem entweder die ersten und/oder zweiten Verunreinigungen ioneninjiziert sind.

7. Verfahren nach Anspruch 2, 3, 4 oder 5, oder 6 in Verbindung mit Anspruch 2, 3, 4 oder 5, bei dem die dritten Verunreinigungen ioneninjiziert werden.

8. Verfahren nach Anspruch 7, ferner mit:
- Bilden einer isolierenden Schicht auf dem Transistorbereich; und
- anschließendem Bilden einer Gateelektrode auf dem Kanalbereich über der isolierenden Schicht,
wobei die dritten Verunreinigungen durch die Gateelektrode und die isolierende Schicht in den Kanalbereich ioneninjiziert werden.

9. Verfahren nach einem der vorhergehenden Ansprüche bei dem die Breite des Kanalbereichs weniger als 2 Mikrometer beträgt.

10. Verfahren nach Anspruch 9, bei dem der FET auf dem Substrat zusammen mit einem anderen FET gebildet wird, der einen Kanalbereich hat, der breiter als 2 Mikrometer ist.

**Revendications**

1. Procédé de fabrication d'un transistor à effet de champ (FET) dans une région de transistor d'un substrat semiconducteur, la région de transistor comportant une région de canal destinée à accueillir la formation du canal du FET, comprenant les opération suivantes:
- injecter sélectivement des premières impuretés, d'un premier type de conductivité, dans le substrat semiconducteur autour de la région de transistor;
- soumettre le substrat semiconducteur à un processus thermique visant à faire diffuser les premières impuretés, ce qui amène les premières impuretés à se répartir dans toute la région de canal ou dans une plus grande partie de celle-ci; et
injecter sélectivement des deuxièmes impuretés, d'un deuxième type de conductivité, dans la région de transistor, de façon que les premières impuretés se trouvant dans au moins la région de canal soient sensiblement compensées par les deuxièmes impuretés.

2. Procédé selon la revendication 1, comprenant en outre l'opération consistant à injecter des troisièmes impuretés dans au moins la région de canal, afin d'ajuster le niveau de seuil du FET à un niveau voulu.

3. Procédé selon la revendication 2, où la concentration des deuxièmes impuretés injectées dans la région de canal est sensiblement égale à la concentration des premières impuretés dans la région de canal, et les troisièmes impuretés sont du deuxième type de conductivité, si bien qu'il peut être produit un FET du type appauvrissement de la deuxième conductivité.

4. Procédé selon la revendication 2, où les troisièmes impuretés sont du premier type de conductivité et la concentration des deuxièmes impuretés injectées dans la région de canal est égale ou supérieure à la concentration des premières impuretés dans la région de canal et inférieure à la somme des concentrations respectives des premières et troisièmes impuretés dans la région de canal, si bien qu'il peut être produit un FET du type enrichissement de la deuxième conductivité.

5. Procédé selon la revendication 4, où on injecte les troisièmes impuretés de manière qu'elles se répartissent plus profondément dans le substrat que les premières impuretés, si bien qu'il est produit un puits du premier type de conductivité dans le substrat semiconducteur, afin d'y former le FET.

6. Procédé selon l'une quelconque des revendications précédentes, où on injecte les premières et, ou bien, les deuxièmes impuretés sous forme ionique.

7. Procédé selon la revendication 2, 3, 4 ou 5, ou selon la revendication 6 prise en dépendance de la revendication 2, 3, 4 ou 5, où on injecte les troisièmes impuretés sous forme ionique.

8. Procédé selon la revendication 7, comprenant en outre les opérations suivantes:
- former une couche isolante sur la région de transistor; et
- former ensuite une électrode de grille sur la région de canal, au-dessus de la couche isolante, les troisièmes impuretés étant injectées sous forme ionique dans la région de canal au travers de l'électrode de grille et de la couche isolante.

9. Procédé selon l'une quelconque des revendications précédentes, où la largeur de la région de canal est inférieure à 2 μm.

10. Procédé selon la revendication 9, où on forme le FET sur le substrat en même temps qu'un autre FET ayant une région de canal plus large que 2 μm.

# FIG. 1A

# FIG. 1B

# FIG. 1C

# FIG. 2

FIG.3A

FIG.3B

FIG.3C

FIG.3D

3

*FIG. 3E*

*FIG. 3F*

*FIG. 3G*

# FIG. 4